(19) **Europäisches Patentamt / European Patent Office / Office européen des brevets**

(11) **EP 2 110 681 A1**

(12) **EUROPEAN PATENT APPLICATION**

(43) Date of publication:
**21.10.2009 Bulletin 2009/43**

(51) Int Cl.:
*G01R 33/48* (2006.01)    *G01R 33/565* (2006.01)

(21) Application number: **08154469.4**

(22) Date of filing: **14.04.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Koninklijke Philips Electronics N.V.**
**5621 BA Eindhoven (NL)**

(72) Inventor: **The designation of the inventor has not yet been filed**

(74) Representative: **Cohen, Julius Simon**
**Philips**
**Intellectual Property & Standards**
**P.O. Box 220**
**5600 AE Eindhoven (NL)**

(54) **Temporal shift correction in diagnostic imaging**

(57)    A method for use in magnetic resonance imaging, or other imaging modality, wherein dynamic data is acquired in which the signal intensity of each pixel has a repetitive nature or in which (a subset of) the pixels have a common line shape. The common line shape of a data set comprising a plurality of signal intensity time curves is estimated by performing principal component analysis (PCA) in respect of the data set using a singular value decomposition (SVD) algorithm, wherein the first principal component is representative of the common line shape. Then, a time shift value is obtained using the common line shape and one or more of its derivatives and linear regression and applied to the respective signal intensity time curves to correct for random temporal shift in the repetitive elements.

FIG. 2

**Description**

FIELD OF THE INVENTION

This invention relates generally to temporal shift correction for the purpose of quantitative analysis of dynamic data acquired with a medical diagnostic imaging modality, such as magnetic resonance imaging (MRI), computed tomography (CT), positron emission tomography (PET).

BACKGROUND OF THE INVENTION

In the field of medical diagnostic imaging, often dynamic data is acquired in which the signal intensity of each pixel has a repetitive nature or in which (a subset of) the pixels have a common line shape, e.g. response curves (also known as signal intensity time curves). Quantitative analysis and compression of these response curves can then be performed in order to extract a reasonable number of clinically relevant parameters.

More specifically, such time curves are acquired voxel-by-voxel and quantitation of the peaks therein is often performed. It has been shown that Principal Component Analysis (PCA) is a promising technique for this purpose in that PCA estimates more quickly and more precisely the peak integral of a series of noisy peaks than least-squares approaches operating on each curve (see, for example, Van Huffel, S. et al, "Automatic Frequency Alignment and Quantitation of Single Resonances in Multiple Magnetic Resonance Spectra via Complex Principal Component Analysis", Journal of Magnetic Resonance, vol. 158, 2002, pp.1-14). However, the PCA quantitation method is sensitive to temporal shifts throughout the data set, and accurate results of the analysis process can only be achieved if there is no temporal shift in the signal intensity (SI) time curves. Such temporal shifts are typically relatively small and can be caused by a variety of factors, including fluctuations in instrumental and experimental parameters as a result of physiological processes in the body or some error during the experiment. For example, in dynamic contrast enhanced MRI, the path length between the location of contrast injection and the location of interest is different for each location in the tissue under investigation. This causes bolus arrival delays that cause corresponding temporal shifts in the resultant SI time curves.

Even though these temporal shifts are typically relatively small, they can cause unacceptably large errors in the results of quantitation of the data set. Thus, before an entire data set can be analyzed in a fully automated fashion using, for example PCA, the temporal shifts in the SI time curves acquired during medical imaging should be corrected.

In "Frequency-Dependent Changes of Regional Cerebral Blood Flow During Finger Movements: Functional MRI compared to PET", by Norihiro Sadato et al, Journal of Cerebral Blood Flow & Metabolism (1997) 17, 670-679, a functional MRI method is described for evaluating the effect of the repetition rate of a simple movement on the magnitude of neuronal recruitment in the primary sensorimotor cortex of a subject. In the described method, functional MRI data is analyzed by calculating correlation coefficients (CC) between the Fourier Tranform of the time course data and the Fourier Transform of a reference waveform. In the above-mentioned reference, the issue of delayed response (and, therefore, potential temporal shifts in the response curve) is addressed in relation to a transitional period only, stating that because the magnetization is not in a steady state for the first three images of each time series set, these are excluded from all analyses. However, any temporal shift in the remainder of the response data will remain uncorrected.

Other methods have been proposed for correction of temporal shifts in SI time curves acquired with MRI. These methods use model functions, wherein the temporal shift is estimated by fitting each SI time curve iteratively to the model. However, in most cases, there is no knowledge about the underlying model for the SI time curves of interest. Furthermore, existing methods iteratively fit the SI time curves to a model function. Since the number of SI time curves is often very large (100,000 or more), this is a time consuming operation.

It is therefore an object of the present invention to provide an improved method and system for correcting temporal shifts in a data set comprising several SI time curves such that all of the SI time curves in the experiment have the same start time point.

SUMMARY OF THE INVENTION

In accordance with the present invention, there is provided imaging apparatus, comprising image acquisition means for acquiring an image data set in respect of a subject, the image data set comprising a plurality of signal intensity time curves, means for estimating from said image data set a common line shape in said data, means for obtaining a first derivative of said common line shape, means for using said first derivative to derive a time shift value in respect of each of said signal intensity time curves, and means for shifting each of said signal intensity time curves by the respective time shift value derived therefor. The shift may be executed in the frequency domain, like in the application for MR Spectroscopy, Alternatively, the shift may be performed directly in the temporal domain. It will be appreciated that it is possible to perform the temporal shift correction using complex data, rather than real (or magnitude) data alone.

Thus, because the present invention uses a common line shape derived from the data itself, it does not assume an underlying model.

In a first exemplary embodiment, the common line shape may be estimated by performing a principal component analysis on the image data set using a singular value decomposition algorithm, wherein the first principal component is representative of the common line shape in said data. In this case, linear regression is preferably used to approximate each time series in respect of the image data set by means of a linear combination of the common line shape and its one or more derivatives. The first two i..e. the lowest order, regression coefficients can then be divided to obtain the time shift.

In a second exemplary embodiment, the common line shape may once again be estimated by performing a principal component analysis on the image data set using a singular value decomposition algorithm, wherein the principal component is representative of the common line shape in said data. In this case, a score value is calculated in respect of said common line shape. A transformation matrix is preferably calculated and used to calculate a second score value, and the two score values can then be divided to obtain the time shift.

In one exemplary embodiment, the imaging apparatus may comprise a magnetic resonance imaging apparatus, although the present invention is not necessarily intended to be limited in this regard.

In accordance with a preferred embodiment of the invention, therefore, singular value decomposition and linear regression are employed on a data matrix that contains all relevant SI time curves. These are both extremely fast methods and, therefore, pose no time constraint.

The present invention extends to a computer program for use with imaging apparatus, the computer program comprising software configured to receive an image data set in respect of a subject, the image data set comprising a plurality of signal intensity time curves, estimate from said image data set a common line shape in said data, means for obtaining a first derivative of said common line shape, use said first derivative to derive a time shift value in respect of each of said signal intensity time curves, and shift each of said signal intensity time curves by the respective time shift value derived therefor.

Also in accordance with the present invention, there is provided a method of performing time shift correction in respect of a data set comprising a plurality of signal intensity time curves derived from image acquisition of a subject, the method comprising estimating from said image data set a common line shape in said data, obtaining a first derivative of said common line shape, using said first derivative to derive a time shift value in respect of each of said signal intensity time curves, and shifting each of said signal intensity time curves by the respective time shift value derived therefor.

## BRIEF DESCRIPTION OF THE DRAWINGS

These and other aspects of the present invention will be apparent from, and elucidated with reference to, the embodiments described herein.

Embodiments of the present invention will now be described by way of examples only and with reference to the accompanying drawings, in which:

Figure 1 is a schematic diagram illustrating a magnetic resonance imaging apparatus in accordance with an exemplary embodiment of the present invention;
Figure 2 illustrates a data set comprising 600 signal intensity (SI) time curves;
Figure 3 is a schematic flow diagram illustrating the principal steps of a temporal shift correction method according to a first exemplary embodiment of the present invention;
Figure 4 is a schematic flow diagram illustrating the principal steps of a temporal shift correction method according to a second exemplary embodiment of the present invention; and
Figure 5 illustrates the data set of Figure 2 after temporal shift correction.

## DETAILED DESCRIPTION OF EMBODIMENTS

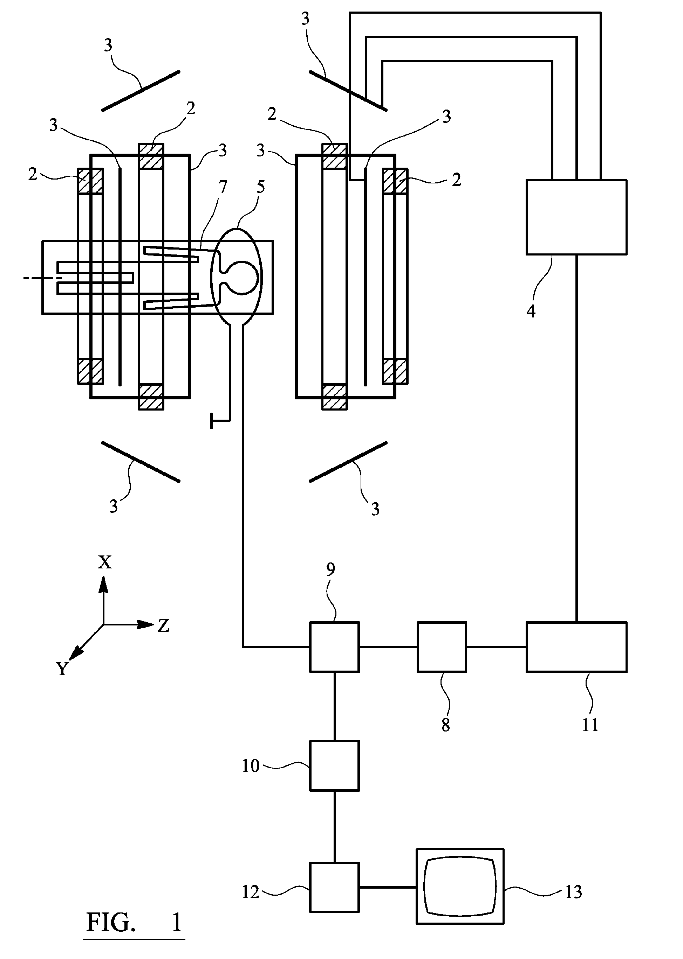

Referring to Figure 1 of the drawings, a practical embodiment of a magnetic resonance device is shown which includes a first magnet system 2 for generating a steady magnetic field and also means for generating additional magnetic fields having a gradient in the X, Y and Z directions, which means are known as gradient coils 3. The Z direction of the co-ordinate system shown corresponds to the direction of the steady magnetic field in the magnet system 2 by convention. The gradient coils 3 are fed by a power supply unit 4. An RF transmitter coil 5 serves to generate RF magnetic fields and is connected to an RF transmitter and modulator 6. A receiver coil is used to receive the magnetic resonance signal generated by the RF field in the subject 7 to be examined. The transmitter coil 5 represents an array of multiple receiver antennae. Furthermore, the magnet system 2 encloses an examination space which is large enough to accommodate a part of the subject 7 to be examined. The RF coil 5 is connected to a signal amplifier and demodulation unit 10 via a transmission/reception circuit 9. The control unit 11 controls the RF transmitter and modulator 6 and the power supply unit 4. The control unit 11 also controls detection of the MR signal(s), the phase and amplitude of which, obtained from the demodulation unit n10, are applied to a processing unit 12. The processing unit 12 processes the presented signal values so as to form an image by transformation and this image can be visualized, for example by means of a monitor 13.

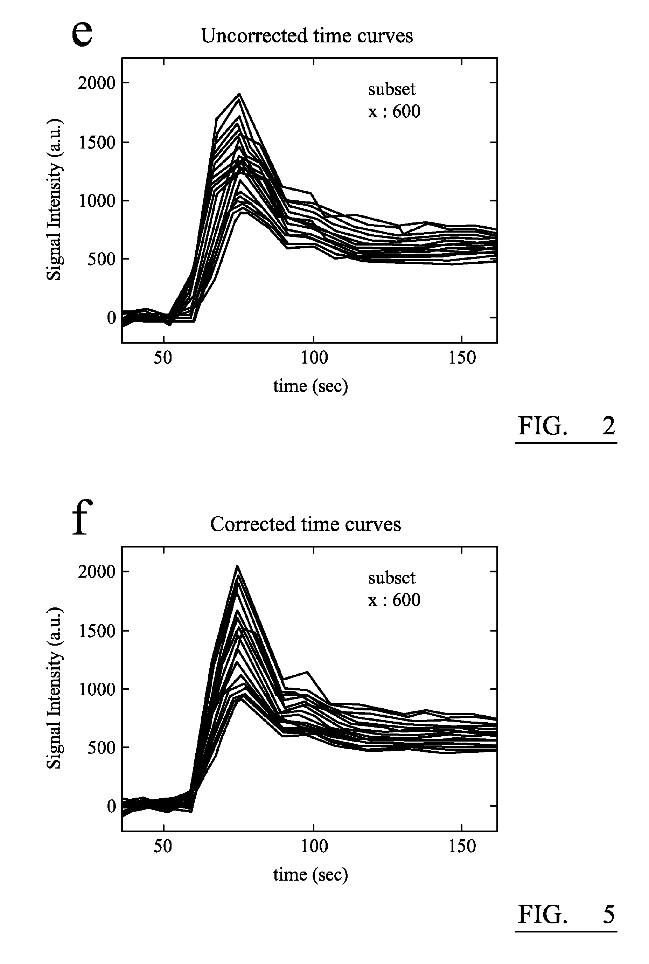

The processing unit receives a data set comprising several (e.g. 600) signal intensity (SI) curves, as illustrated in Figure 2 of the drawings. As explained in detail above, it is an object of the present invention to provide a method for correcting temporal shifts in a data set such as that illustrated in Figure 2.

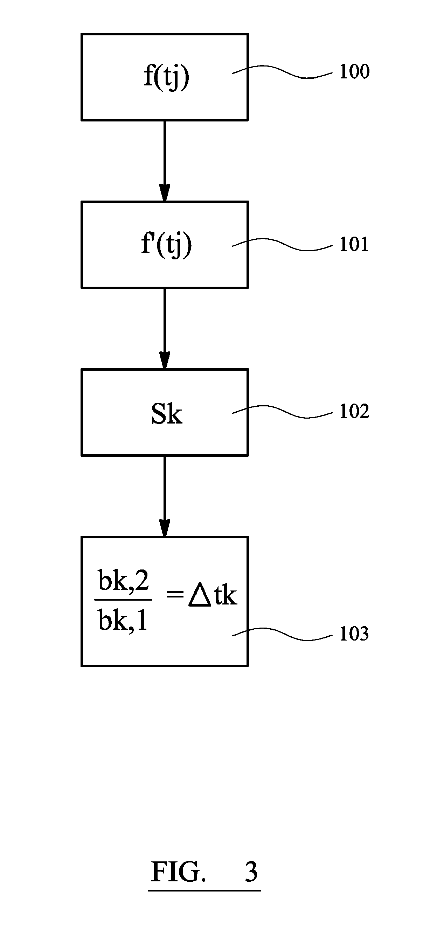

Referring to Figure 3 of the drawings, in a first exemplary embodiment of a method according to the invention, only 5 steps are needed to perform the desired operation of detecting and correcting the signal intensity curves. Key steps:

100. Estimate a common lineshape in the data. The common lineshape can be estimated with several methods. They all calculate row and column singular vectors and a square diagonal matrix with eigenvalues. The singular vectors are orthogonal and the one with the highest eigenvalue is in the direction of the highest variance in the data. Several methods exist: Singular value decomposition, NIPALS, Golub-Reinsch SVD, power algorithm (data handling in Science and technology 20b, p139). However, other ways of calculating common lineshapes could also be used, e.g. the mean of the signal intensity curves.

101. Calculate the p first derivatives of the common lineshape of the data (only the first derivative is especially relevant).

102. Using linear regression, each time series k is approximated by a linear combination of the common lineshape and its derivatives. This is based on theory that uses Taylor series expansion, which will be described in more detail below. It will be appreciated that inversion of the X matrix is desirable if the method is required to be relatively fast.

103. Divide first two regression coefficients to get the desired time shift for each time series.

104. Perform e.g. an inverse Fourier transform (IFFT) to perform the shift in the frequency domain. Subsequently perform an FFT to obtain the time shifted time series. Time shifting with the use of FFT is a rather expensive, but elegant way to obtain a shift which is smaller than a time sample. Other methods, e.g. interpolation schemes, are also possible to perform the time shift.

105. Possibly, iterate until the time shifts become negligible or below a certain threshold.

Describing the above method mathematically:

Each time series $S_k$ (without noise) in a large (Modulus) time series which have a common line shape with different amplitude, and which are possibly shifted in time, can be described as,

$$S_k(t_j) = A_k \cdot f(t_j + \Delta t_k)$$

Where $S_k(t_j)$ is the discrete signal of the $k$th time series at time point $t_j$, $A_k$ is the amplitude of time series $k$, $f(t_j)$ is the lineshape function and $\Delta t_k$ is the time shift $k$.

The basic idea is to expand $S_k(t_j)$ in a Taylor series. Equation 1 then becomes,

$$S_k(t_j) = A_k \left\{ f(t_j) + \left| \frac{df}{dt} \right|_{tj} \Delta t_k + \frac{1}{2} \left| \frac{d^2 f}{dt^2} \right|_{tj} \Delta t^2{}_k + \ldots \ldots \right\}$$

$S_k(t_j)$ can be rewritten as,

$$S_k(t_j) = A_k \left\{ f(t_j) + \Delta t_k f'(t_j) + \frac{1}{2} \Delta t^2{}_k f''(t_j) + \ldots \ldots \right\}$$

where $f'(t_j)$ is the first derivative of $f(t_j)$ and so on.
$S_k(t_j)$ can be rewritten as,

$$S_k(t_j) = b_{k,1} f(t_j) + b_{k,2} f'(t_j) + b_{k,3} f''(t_j) + \ldots.$$

where $b_{k,i}$ is the $i$th Taylor coefficient of time series $k$. The coefficients $b_{k,1}$,...etc, can be calculated with the classical least-squares solution (linear regression) for all time series within one calculation. Then, the second Taylor coefficient contains the shift information.

$$\frac{b_{k,2}}{b_{k,1}} = \frac{A_k \Delta t_k}{A_k} = \Delta t_k$$

The key, therefore, is to estimate the common lineshape $f(t_j)$ and calculate its signal containing derivatives ($f'(t_j)$, etc). Approximation of the common lineshape can be done by SVD, taking the first principal component (PC1) as common lineshape. In more detail, therefore, a proposed exemplary temporal shift correction procedure starts with a Principal Component Analysis (PCA) of the time series using the SVD algorithm. The SVD algorithm is applied to the data matrix D in which the rows represent the time series and the columns represent the respective signal intensities. It calculates the first principal component (PC1) normalised to unit length and, subsequently one or more of its derivatives. Then using linear regression, each time series k is approximated by a linear combination of the $PC_1$ and its derivatives. This results in values for $b_{k,2}$ and $b_{k,1}$, from which $\Delta t_k$ can be calculated. Using $\Delta t_k$ the time series k can be corrected. This is described in detail for frequency shift correction of single resonance lines in spectral data sets in "Witjes et al., Automatic Correction for phase shifts, frequency shifts and lineshape distortions across a series of single resonance lines in large spectral data sets, JMR 144, 35-44 (2000)"

The procedure is repeated until convergence occurs. After convergence, the PC1 will approximate $f(t_j)$ very well.

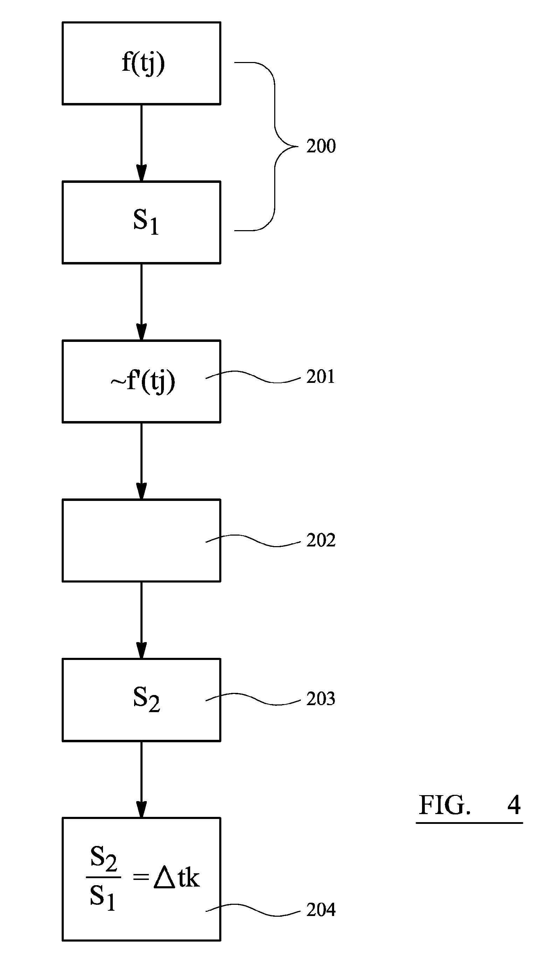

Referring to Figure 4 of the drawings, an alternative exemplary method according to the present invention is slightly more complicated, but uses the same starting principles:

200. If we consider a dataset of time series with a common lineshape with varying amplitude, then the PC1 will be an estimate of that common lineshape. If there are small time shift variations between the time series, then the second PC (PC2) will describe the variance due to the time shift and will have the shape of the derivative of the common lineshape. Thus, once again, PCA is performed on the time series using the SVD algorithm, to obtain PC1 and PC2. To determine the amplitudes of PC1 and PC2, the scores on PC 1 and PC2 are also calculated by calculating the score matrix: $S_{1,2} = D(PC_{1,2})^T$ (where T denotes the matrix transpose).

201. Estimate the first derivative of the common lineshape of the data ($PC_1$').

202. A transformation matrix is calculated which transforms the coordinate system defined by (PC1 and PC2) to a new coordinate system defined by (PC1 and $PC_1$'). The scores of each time series on the PC1 and PC2 are projected onto this new coordinate system exploiting the above transformation matrix (or its inverse).

203. Thus, the transformation matrix can now be used to calculate a second score value, $S_D$, which is the projection of score $S_2$ on $PC_1$'.

204. The two scores $S_D$ and $S_1$ are divided, and the resultant value is representative of the required time shift.

205. Finally, the shift is applied to the time series and the process iterated as required.

Figure 5 illustrates the time series of Figure 2 after temporal shift correction in accordance with an exemplary embodiment of the invention.

There are a number of potential applications in which the methods described above can be used, and the present invention is not intended to be limited in this regard. However, some examples of relevant applications are given below for illustrative purposes.

- Dynamic contrast enhanced imaging: in the brain, it is clinically relevant to know the bolus arrival time in the arterial/venous bed in the sense that information relating to early arrivals can be used to select pixels that are in the arteries. Thus temporal shift information is relevant for the Arterial Input Function (AIF) estimation. After temporal shift correction, the pixels selected for AIF estimation will generate a more reliable AIF curve since there is no shift error.
- Functional MRI: in fMRI, a dynamic response curve is acquired that contains many repetitive elements. These repetitive elements have a common line shape. In many experiments, the common lineshape in the repetitive elements is shifted, dependent on the reaction time of the patient. This may happen, for example, in tapping experiments when a patient does not start tapping immediately after the onset of the stimulus. The variation in the shift of the repetitive elements can be corrected by putting each repetitive element in a row of a 2D matrix, performing the proposed correction and restoring the signal.
- Cardiovascular: in cardiovascular experiments, there are many repetitive elements in the data due to the beating of the heart. To correct for specific problems that do not have an underlying model function, the proposed method may be used.
- Angio: the proposed method can be used to generate quantitative bolus arrival time images in the arterial/venous bed for the whole body.

The method of the present invention can be implemented by a computer program comprising code means for execution by a data processor. The computer program code may be embodied on a computer readable medium, for example a magnetic medium, such as a disk, an optical medium, such as a CD ROM, or a solid-state medium, such as flash memory. In that case it is possible for the computer program to be a retro-fit upgrade to an existing medical imaging apparatus.

It will be appreciated that, while the present invention has been described above in relation to magnetic resonance imaging, it is equally applicable to other imaging modalities whereby a data set comprising a large number of signal intensity time curves can be acquired which are potentially temporally shifted, e.g. computed tomography, positron emission tomography, etc.

It should be noted that the above-mentioned embodiments illustrate rather than limit the invention, and that those skilled in the art will be capable of designing many alternative embodiments without departing from the scope of the invention as defined by the appended claims. In the claims, any reference signs placed in parentheses shall not be construed as limiting the claims. The word "comprising" and "comprises", and the like, does not exclude the presence of elements or steps other than those listed in any claim or the specification as a whole. The singular reference of an element does not exclude the plural reference of such elements and vice-versa. The invention may be implemented by means of hardware comprising several distinct elements, and by means of a suitably programmed computer. In a device claim enumerating several means, several of these means may be embodied by one and the same item of hardware. The mere fact that certain measures are recited in mutually different dependent claims does not indicate that a combination of these measures cannot be used to advantage.

**Claims**

1. Imaging apparatus, comprising image acquisition means for acquiring an image data set in respect of a subject, the image data set comprising a plurality of signal intensity time curves, means for estimating from said image data set a common line shape in said data, means for obtaining a first derivative of said common line shape, means for using said first derivative to derive a time shift value in respect of each of said signal intensity time curves, and means for shifting each of said signal intensity time curves by the respective time shift value derived therefor.

2. Apparatus according to claim 1, wherein the common line shape is estimated by performing a principal component analysis on the image data set using a singular value decomposition algorithm, wherein the first principal component is representative of the common line shape in said data.

3. Apparatus according to claim 2, wherein linear regression is used to approximate each time series in respect of the image data set by means of a linear combination of the common line shape and its one or more derivatives.

4. Apparatus according to claim 3, wherein two regression coefficients are divided to obtain said time shift.

5. Apparatus according to claim 2, wherein a score value is calculated in respect of said common line shape.

6. Apparatus according to claim 5, wherein a transformation matrix is calculated and used to calculate a second score value, and the two score values are divided to obtain said time shift.

7. A computer program for use with imaging apparatus, the computer program comprising software configured to receive an image data set in respect of a subject, the image data set comprising a plurality of signal intensity time curves, estimate from said image data set a common line shape in said data, means for obtaining a first derivative of said common line shape, use said first derivative to derive a time shift value in respect of each of said signal intensity time curves, and shift, in the frequency domain, each of said signal intensity time curves by the respective time shift value derived therefor.

8. A computer program according to claim 7, wherein the common line shape is estimated by performing a principal component analysis on the image data set using a singular value decomposition algorithm, wherein the first principal component is representative of the common line shape in said data.

9. A method of performing time shift correction in respect of a data set comprising a plurality of signal intensity time curves derived from image acquisition of a subject, the method comprising estimating from said image data set a common line shape in said data, obtaining a first derivative of said common line shape, using said first derivative to derive a time shift value in respect of each of said signal intensity time curves, and shifting each of said signal intensity time curves by the respective time shift value derived therefor.

10. A method according to claim 9, wherein the common line shape is estimated by performing a principal component analysis on the image data set using a singular value decomposition algorithm, wherein the first principal component is representative of the common line shape in said data.

FIG. 1

e

## Uncorrected time curves

FIG. 2

f

## Corrected time curves

FIG. 5

$$f(t_j) \quad \text{---} 100$$

$$f'(t_j) \quad \text{---} 101$$

$$S_k \quad \text{---} 102$$

$$\frac{b_{k,2}}{b_{k,1}} = \triangle t_k \quad \text{---} 103$$

FIG. 3

f(tj)

$S_1$

200

~f'(tj)

201

202

$S_2$

203

$$\frac{S_2}{S_1} = \triangle tk$$

204

FIG.  4

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | SIMONETTI AW ET AL: "Model free bolus arrival time estimation for dynamic contrast MR studies" PROCEEDINGS OF THE INTERNATIONAL SOCIETY FOR MAGNETIC RESONANCE IN MEDICINE, 16TH SCIENTIFIC MEETING AND EXHIBITION, TORONTO, CANADA, 3-9 MAY 2008, 3 May 2008 (2008-05-03), page 1903, XP002496719 * the whole document * | 1-10 | INV. G01R33/48 G01R33/565 |
| X | ANDERSEN AH ET AL: "PCA for mapping time delays in the transient response from functional MRI studies" PROCEEDINGS OF THE INTERNATIONAL SOCIETY FOR MAGNETIC RESONANCE IN MEDICINE, 9TH SCIENTIFIC MEETING AND EXHIBITION, GLASGOW, SCOTLAND, UK, 21-27 APRIL 2001, 21 April 2001 (2001-04-21), page 1720, XP002496720 * the whole document * | 1-10 | |
| Y | | 1-10 | TECHNICAL FIELDS SEARCHED (IPC) G01R G01N G01V A61B |
| Y | IBARAKI M ET AL: "Tracer delay correction of cerebral blood flow with dynamic susceptibility contrast-enhanced MRI" JOURNAL OF CEREBRAL BLOOD FLOW & METABOLISM, vol. 25, 2005, pages 378-390, XP009106009 Sections "Introduction", "Methods" | 1-10 | |

-/--

The present search report has been drawn up for all claims

| Place of search | Date of completion of the search | Examiner |
|---|---|---|
| Munich | 25 September 2008 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 08 15 4469

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WITJES H ET AL: "Automatic Correction for Phase Shifts, Frequency Shifts, and Lineshape Distortions across a Series of Single Resonance Lines in Large Spectral Data Sets" JOURNAL OF MAGNETIC RESONANCE, ACADEMIC PRESS, ORLANDO, FL, US, vol. 144, no. 1, 1 May 2000 (2000-05-01), pages 35-44, XP004406931 ISSN: 1090-7807 * the whole document * | 1-10 | |
| A | CHEONG LH ET AL: "An automatic approach for estimating bolus arrival time in dynamic contrast MRI using piecewise continuous regression models" PHYSICS IN MEDICINE AND BIOLOGY, 2003, pages N83-N88, XP002496721 * the whole document * | 1-10 | |
| A,D | SADATO N ET AL: "Frequency-dependent changes of regional cerebral blood flow during finger movements: Functional MRI compared to PET" JOURNAL OF CEREBRAL BLOOD FLOW & METABOLISM, vol. 17, 1997, pages 670-679, XP002496722 * the whole document * | 1-10 | TECHNICAL FIELDS SEARCHED (IPC) |

The present search report has been drawn up for all claims

| Place of search | Date of completion of the search | Examiner |
|---|---|---|
| Munich | 25 September 2008 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                           
& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **Van Huffel, S. et al.** Automatic Frequency Alignment and Quantitation of Single Resonances in Multiple Magnetic Resonance Spectra via Complex Principal Component Analysis. *Journal of Magnetic Resonance,* 2002, vol. 158, 1-14

- **Norihiro Sadato et al.** Frequency-Dependent Changes of Regional Cerebral Blood Flow During Finger Movements: Functional MRI compared to PET. *Journal of Cerebral Blood Flow & Metabolism,* 1997, vol. 17, 670-679
- *JMR,* 2000, vol. 144, 35-44